# EUROPÄISCHE PATENTSCHRIFT

(11) **EP 3 267 771 B1**
(45) Veröffentlichungstag und Bekanntmachung des Hinweises auf die Patenterteilung: **18.03.2020**
(21) Anmeldenummer: 17178381.4
(22) Anmeldetag: 28.06.2017
(51) Int. Cl.: H05K 7/14

(54) **MECHANISMUS ZUR LEITERPLATTENFIXIERUNG**
MECHANISM FOR PCB FIXING
MÉCANISME DE FIXATION DE CIRCUIT IMPRIMÉ

(30) Priorität: 08.07.2016 DE 102016212518
(43) Veröffentlichungstag der Anmeldung: 10.01.2018
(73) Patentinhaber: Siemens Schweiz AG, 8047 Zürich (CH)
(72) Erfinder: Penzkofer, Martin, 94356 Pillnach (DE)
(74) Vertreter: Maier, Daniel Oliver

(56) Entgegenhaltungen:
- EP-A1- 2 355 262
- JP-A- H10 294 576
- US-A- 5 281 149

## Beschreibung

Die Erfindung betrifft einen Schnappmechanismus zum Fixieren einer Leiterplatte in einer Gehäuseschale. Weiterhin betrifft die Erfindung ein System und einen Teilnehmer eines Installationsbusses, jeweils umfassend den Schnappmechanismus.

Gehäuseteile, wie Gehäuseschalen, werden z.B. bei der Abdeckung von elektrischen Geräten verwendet. Bei einem elektrischen Gerät kann es sich z.B. um ein Raumautomationsmodul mit Sensoren und/oder Aktoren zur Klimasteuerung in einem Gebäude handeln. Die elektrischen Geräte beinhalten üblicherweise elektronische Bauteile und Schaltungselemente, die auf einer Leiterplatte angeordnet sind.

Üblicherweise bestehen elektrische bzw. elektronische Geräte somit im Wesentlichen aus einem aus Kunststoff bestehenden Gehäuse bzw. aus Gehäuseteilen zur Aufnahme von Funktions- bzw. Bauelementen, wobei die Funktions- bzw. Bauelemente auf einer im Gehäuse befindlichen Leiterplatte bzw. Flachbaugruppe angeordnet sind.

Zur Montage der Leiterplatte bzw. der Flachbaugruppe im Gehäuse ist es bekannt Schraub- oder Schnappmechanismen zu verwenden. Oft sind dabei zusätzliche Komponenten, wie z.B. Abstandshalter erforderlich. Weiterhin kann durch Einlegen der Leiterplatte in eine erste Gehäusehälfte und anschließender Montage einer weiteren Gehäusehälfte eine Fixierung der Leiterplatte im Gehäuse erfolgen.

Die japanische Patentanmeldung JP H10294576A offenbart einen Schnappmechanismus zum Fixieren einer Leiterplatte in einer Gehäuseschale, wobei durch ein mechanisches Eindrücken der Leiterplatte eine Fixierung der Leiterplatte mit der Gehäuseschale mit erfolgt.

Die europäische Patentanmeldung EP2355262A1 offenbart ein elektronisches Gerät mit einer ersten und zweiten Leiterplatte, sowie einen Steckmechanismus zum Fixieren der Leiterplatten im Gerät.

Die amerikanische Patentschrift US5281149A offenbart einen Abstandshalter für Leiterplatten mit einem Gehäuse, um einen vorgegebenen Mindestabstand zwischen den Leiterplatten sicherzustellen.

Bei den aus dem Stand der Technik bekannten Mechanismen für die Fixierung von Leiterplatten innerhalb eines Gehäuses für ein elektronisches Gerät (z.B. Busteilnehmer eines Installationsbuses) sind somit zusätzliche Komponenten oder Werkzeuge nötig.

Es ist daher die Aufgabe der vorliegenden Erfindung, einen Schnappmechanismus bereitzustellen, der eine schnelle und werkzeuglose Fixierung einer Leiterplatte in einem Gehäuse ermöglicht.

Die Aufgabe wird gelöst durch einen Schnappmechanismus zum Fixieren einer Leiterplatte in einer Gehäuseschale gemäß Anspruch 1. Hierbei weist die Gehäuseschale in ihrer Geometrie einen Steckerkörper mit einem ersten und einem zweiten Steckelement auf, wobei ein Steckelement ein zur Leiterplatte hin abgeschrägtes Einführelement und eine zum Leiterplattenrand weisende Schnappnase aufweist; wobei der Steckerkörper zwischen dem ersten und dem zweiten Steckelement einen Steg mit einer zur Leiterplatte hin abgeschrägten Wand aufweist, wodurch an der Innenwand des Steckerkörpers eine Haltekante gebildet wird; wobei die Leiterplatte zwei Aussparungen aufweist, in die das erste und das zweite Steckelement durchgreifen; wobei die Leiterplatte zwischen den Aussparungen eine Schnappzunge aufweist; und wobei durch ein mechanisches Eindrücken der Leiterplatte auf den Steckerkörper durch Anliegen der Schnappzunge an der Haltekante und durch formschlüssige Verbindung der Schnappnasen mit der Leiterplatte eine Fixierung der Gehäuseschale mit der Leiterplatte erfolgt. Der Schnappmechanismus ermöglicht eine schnelle und schraubenlose Fixierung einer Leiterplatte in nur einem Kunststoffgehäuse (z.B. einer Gehäuseschale), d.h. ohne, dass ein zweites Gehäuseteil (z.B. zweite Gehäusehälfte) zur Fixierung der Leiterplatte benötigt wird. Die Fixierung erfolgt ohne Zuhilfenahme eines Werkzeugs oder weiterer Komponenten (z.B. Abstandshalter) und bietet auch eine ausreichende Fixierung der Leiterplatte zur weiteren Endmontage des Geräts.

Durch das Zusammenwirken der speziellen Geometrie in der Leiterplatte mit dem der entsprechenden Geometrie im Kunststoffgehäuse wird die Leiterplatte in ihrer Lage im Gehäuse fixiert. Auch andere relativ unflexible Komponenten können prinzipiell durch den erfindungsgemässen Schnappmechanismus in ihrer Lage fixiert werden. Mit Vorteil wird die Haltekante zwischen dem Unterteil der Wand und der Gehäuseschale an der Innenwand der Gehäuseschale gebildet.

Unter dem Begriff Leiterplatte ist dabei sowohl die einzelne Leiterplatte als auch die bestückte Leiterplatte, also die Flachbaugruppe zu verstehen.

Eine erste vorteilhafte Ausgestaltung der Erfindung liegt darin, dass die Leiterplatte an einer stirnseitigen Wand eine Ausnehmung aufweist, wobei die zwei Aussparungen und die Schnappzunge durch die Kontur der Ausnehmung gebildet sind. Eine Leiterplatte mit einer Ausnehmung an ihrem stirnseitigen Rand kann leicht hergestellt werden, z.B. durch Ausfräsen der Ausnehmung.

Eine weitere vorteilhafte Ausgestaltung der Erfindung liegt darin, dass die Kontur der Ausnehmung auf einen Fräskopf zur Herstellung der Leiterplatte abgestimmt ist. Wenn die Dimension des Fräskopfes auf die auszufräsende Ausnehmung abgestimmt ist, wird die Herstellung der Leiterplatte weiter vereinfacht.

Eine weitere vorteilhafte Ausgestaltung der Erfindung liegt darin, dass der mechanische Schnappwiderstand beim Eindrücken der Leiterplatte durch die Dimensionierung der Schnappzunge festlegbar ist. Die für die Montage der Leiterplatte notwendige Druckkraft zur Überwindung des Schnappwiederstandes kann somit jederzeit angepasst werden. Die Anpassung kann ohne anfallende Werkzeugkosten für etwaiges Gehäusewerkzeugs erfolgen. Eine Änderung bzw. Anpassung des Schnappwiderstandes kann z.B. im Zuge einer Leiterplattenänderung mitgemacht werden, indem die "Zunge" der Leiterplatte vergrößert (Erhöhung des Schnappwiederstandes) oder verkleiner (Verringerung des Schnappwiederstandes) wird.

Eine weitere vorteilhafte Ausgestaltung der Erfindung liegt darin, dass der mechanische Schnappwiderstand beim Eindrücken der Leiterplatte durch den Abschrägwinkel der abgeschrägten Wand festlegbar ist. Auch durch eine Änderung des Abschrägwinkels ist der mechanische Schnappwiderstand beim Eindrücken veränder- bzw. anpassbar. An der Schräge gleitet die Leiterplattenzugen bei der Montage nach unten und definiert dadurch den Grad der Durchbiegung am Gehäuse während der Montage.

Eine weitere vorteilhafte Ausgestaltung der Erfindung liegt darin, dass eine Fixierung der Gehäuseschale mit der Leiterplatte weiterhin erfolgt durch eine im wesentlichen bündige Verbindung des Randes einer Aussenwand der Leiterplatte mit der Stirnkante der Gehäuseschale. Dadurch wird insbesondere eine stabile Lage der Leiterplatte im Gehäuse sichergestellt. Nach der Fixierung ist die Leiterplatte in ihrer Lageebene bezüglich des Gehäuses nicht mehr bewegbar.

Eine weitere vorteilhafte Ausgestaltung der Erfindung liegt darin, dass durch ein mechanisches Eindrücken der Leiterplatte auf den Steckerkörper durch Einrasten der Schnappzunge in der Haltekante, durch formschlüssige Verbindung der Schnappnasen mit der Leiterplatte, und durch die im wesentlichen bündige Verbindung des Randes einer Aussenwand der Leiterplatte mit der Stirnkante der Gehäuseschale eine Fixierung der Leiterplatte in horizontaler und/oder vertikaler Richtung in Bezug zur Lage der Gehäuseschale erfolgt. Nach der Fixierung ist die Leiterplatte in ihrer Lageebene bezüglich des Gehäuses nicht mehr bewegbar.

Die Aufgabe wird weiterhin gelöst durch ein System zur Fixierung einer Leiterplatte in einem Gehäuseteil, insbesondere in einer Gehäuseschale, das System umfassend den erfindungsgemässen Schnappmechanismus. Die Leiterplatte wird umso stabiler und fester in ihrer Lage fixiert, je mehr erfindungsgemässe Schnappmechanismen das System aufweist. Mit Vorteil befindet sich an jeder Stirnseite der Leiterplatte ein erfindungsgemässer Schnappmechanismus. Mit Vorteil befindet sich der erfindungsgemässe Schnappmechanismus jeweils mittig an einer Stirnseite der Leiterplatte.

Eine weitere vorteilhafte Ausgestaltung der Erfindung liegt darin, dass das Gehäuseteil und die im Gehäuseteil zu fixierende Leiterplatte dazu ausgebildet sind, dass sich zwei erfindungsgemässe Schnappmechanismen an einander gegenüberliegenden Stirnseiten der Leiterplatte befinden. Mit Vorteil befinden sich die zwei erfindungsgemässen Schnappmechanismen jeweils mittig an den gegenüberliegenden Stirnseiten der Leiterplatte.

Eine weitere vorteilhafte Ausgestaltung der Erfindung liegt in einem Teilnehmer eines Installationsbusses, der mindestens einen erfindungsgemässen Schnappmechanismus umfasst, zur Fixierung einer Leiterplatte in einem Gehäuseteil des Teilnehmers. Solche Busteilnehmer (z.B. Aktoren oder Sensoren zur Gebäudesteuerung) können leicht hergestellt werden.

Die Erfindung sowie vorteilhafte Ausführungen der vorliegenden Erfindung werden am Beispiel der nachfolgenden Figuren erläutert. Dabei zeigen:
- FIG 1: eine erste beispielhafte Prinzipdarstellung des erfindungsgemässen Schnappmechanismus,
- FIG 2: eine zweite beispielhafte Prinzipdarstellung des erfindungsgemässen Schnappmechanismus,
- FIG 3: eine dritte beispielhafte Prinzipdarstellung des erfindungsgemässen Schnappmechanismus,
- FIG 4: eine vierte beispielhafte Prinzipdarstellung des erfindungsgemässen Schnappmechanismus,
- FIG 5: eine fünfte beispielhafte Prinzipdarstellung des erfindungsgemässen Schnappmechanismus,
- FIG 6: eine sechste beispielhafte Prinzipdarstellung des erfindungsgemässen Schnappmechanismus, und
- FIG 7: eine siebte beispielhafte Prinzipdarstellung des erfindungsgemässen Schnappmechanismus.

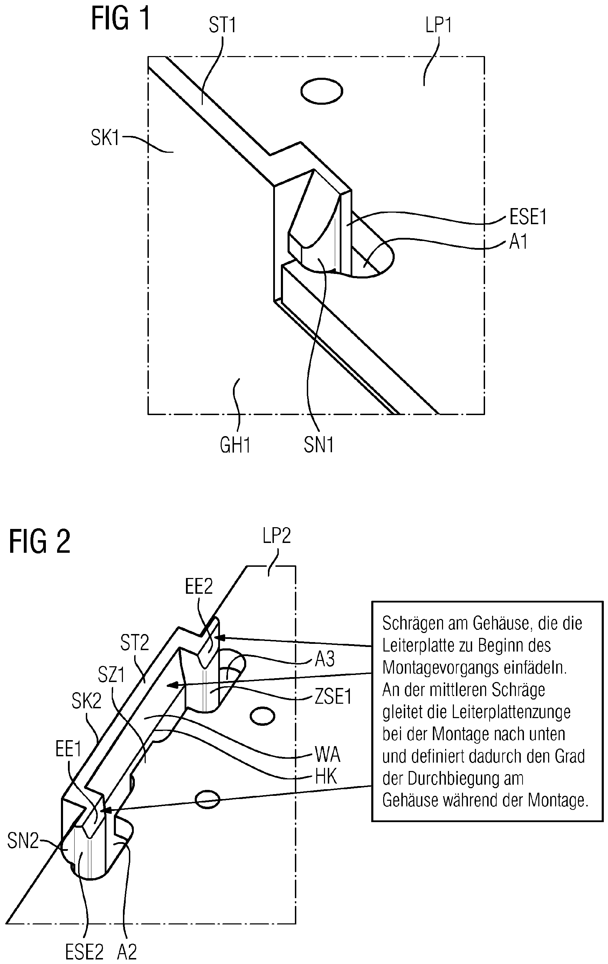

Figur 1 zeigt eine erste beispielhafte Prinzipdarstellung des erfindungsgemässen Schnappmechanismus, zum Fixieren einer Leiterplatte LP1 in einer Gehäuseschale GH1, wobei die Gehäuseschale GH1 in ihrer Geometrie einen Steckerkörper SK1 mit einem ersten ESE1 und einem zweiten Steckelement aufweist (das zweite Steckelement ist in der Darstellung gemäss Figur 1 nicht sichtbar), wobei ein Steckelement ESE1 ein zur Leiterplatte ZPl hin abgeschrägtes Einführelement (in der Darstellung gemäss Figur 1 nicht sichtbar) und eine zum Leiterplattenrand weisende Schnappnase SN1 aufweist; wobei der Steckerkörper SK1 zwischen dem ersten ESE1 und dem zweiten Steckelement einen Steg ST1 mit einer zur Leiterplatte LP1 hin abgeschrägten Wand aufweist, wodurch an der Innenwand des Steckerkörpers SK1 eine Haltekante gebildet wird (abgeschrägte Wand und Haltekante sind in der Darstellung gemäss Figur 1 nicht sichtbar); wobei die Leiterplatte LP1 zwei Aussparungen aufweist (in der Darstellung gemäss Figur 1 ist nur eine Aussparung A1 sichtbar), in die das erste ESE1 und das zweite Steckelement durchgreifen (das zweite Steckelement ist in der Darstellung gemäss Figur 1 nicht sichtbar); wobei die Leiterplatte LP1 zwischen den Aussparungen eine Schnappzunge aufweist (die Schnappzunge ist in der Darstellung gemäss Figur 1 nicht sichtbar); wobei durch ein mechanisches Eindrücken der Leiterplatte LP1 auf den Steckerkörper SK1 durch Anliegen der Schnappzunge an der Haltekante und durch formschlüssige Verbindung der Schnappnasen mit der Leiterplatte LP1 eine Fixierung der Gehäuseschale GH1 mit der Leiterplatte LP1 erfolgt. Mit Vorteil wird die Haltekante zwischen dem Unterteil der Wand und der Gehäuseschale an der Innenwand der Gehäuseschale GH1 gebildet.

Figur 2 zeigt eine zweite beispielhafte Prinzipdarstellung des erfindungsgemässen Schnappmechanismus zum Fixieren einer Leiterplatte LP2 in einer Gehäuseschale (die Gehäuseschale ist in der Darstellung gemäss Figur 2 nicht sichtbar; sie befindet sich unterhalb des Steckerkörpers), wobei die Gehäuseschale in ihrer Geometrie einen Steckerkörper SK2 mit einem ersten ESE2 und einem zweiten Steckelement ZSE2 aufweist, wobei ein jeweiliges Steckelement ESE2, ZSE2 ein zur Leiterplatte LP2 hin abgeschrägtes jeweiliges Einführelement EE1, EE2 und eine zum Leiterplattenrand weisende Schnappnase SN2 aufweist (in der Darstellung gemäss Figur 2 ist nur eine Schnappnase sichtbar); wobei der Steckerkörper SK2 zwischen dem ersten ESE2 und dem zweiten Steckelement ZSE2 einen Steg ST2 mit einer zur Leiterplatte LP2 hin abgeschrägten Wand WA aufweist, wodurch an der Innenwand des Steckerkörpers SK1 eine Haltekante HK gebildet wird; wobei die Leiterplatte LP2 zwei Aussparungen A2, A3 aufweist, in die das erste ESE2 und das zweite ZSE2 Steckelement durchgreifen; wobei die Leiterplatte LP2 zwischen den Aussparungen A2, A3 eine Schnappzunge SZ1 aufweist; wobei durch ein mechanisches Eindrücken der Leiterplatte LP2 auf den Steckerkörper SK2 durch Anliegen der Schnappzunge SZ1 an der Haltekante HK und durch formschlüssige Verbindung der Schnappnasen SN2 mit der Leiterplatte LP2 eine Fixierung der Gehäuseschale mit der Leiterplatte LP2 erfolgt.

Mit Vorteil wird die Haltekante HK zwischen dem Unterteil der Wand WA und der Gehäuseschale an der Innenwand der Gehäuseschale gebildet.

Mit Vorteil weist die Leiterplatte LP2 an einer stirnseitigen Wand eine Ausnehmung auf, wobei die zwei Aussparungen A2, A3 und die Schnappzunge SZ1 durch die Kontur der Ausnehmung gebildet sind.

Schrägen am Gehäuse bzw. am Steckerkörper SK2 oder den Einfuhrelementen EE1, EE2 unterstützen die Leiterplatte LP2 zu Beginn des Montagevorgangs einzufädeln. An der mittleren Schräge (der Wand WA) gleitet die Leiterplattenzunge SZ1 bei der Montage nach unten und definiert dadurch den Grad der Durchbiegung am Gehäuse während der Montage.

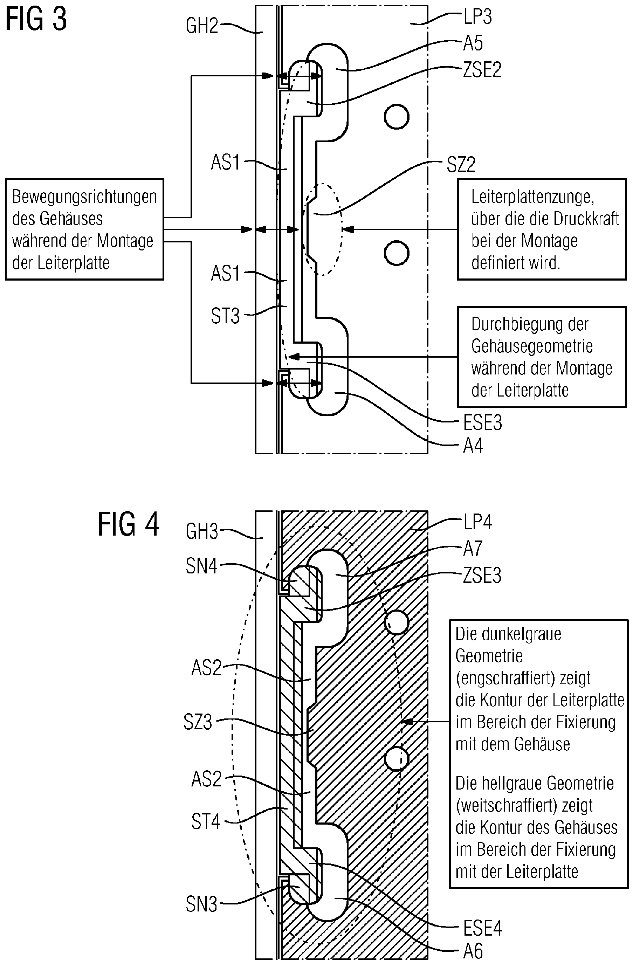

Figur 3 zeigt eine dritte beispielhafte Prinzipdarstellung des erfindungsgemässen Schnappmechanismus, zum Fixieren einer Leiterplatte LP3 in einer Gehäuseschale GH2, wobei die Gehäuseschale GH2 in ihrer Geometrie einen Steckerkörper mit einem ersten ESE3 und einem zweiten Steckelement ZSE2 aufweist, wobei ein Steckelement ESE3, ZSE2 jeweils ein zur Leiterplatte LP3 hin abgeschrägtes Einführelement und eine zum Leiterplattenrand weisende Schnappnase aufweist; wobei der Steckerkörper zwischen dem ersten ESE3 und dem zweiten ZSE2 Steckelement einen Steg ST3 mit einer zur Leiterplatte LP3 hin abgeschrägten Wand aufweist, wodurch eine Haltekante zwischen dem Unterteil der Wand und der Gehäuseschale GH2 an der Innenwand der Gehäuseschale GH2 gebildet wird; wobei die Leiterplatte LP3 zwei Aussparungen A4, A5 aufweist, in die das erste ESE3 und das zweite ZSE2 Steckelement durchgreifen; wobei die Leiterplatte LP3 zwischen den Aussparungen A4, A5 eine Schnappzunge SZ2 aufweist; und wobei durch ein mechanisches Eindrücken der Leiterplatte LP3 auf den Steckerkörper durch Anliegen der Schnappzunge SZ2 an der Haltekante und durch formschlüssige Verbindung der Schnappnasen mit der Leiterplatte LP3 eine Fixierung der Gehäuseschale GH2 mit der Leiterplatte LP3 erfolgt.

In der Darstellung gemäss Figur 3 stellen die Pfeile Bewegungsrichtungen des Gehäuses GH2 während der Montage der Leiterplatte LP3 dar. Über die Leiterplattenzunge (Schnappzunge SZ2) wird die Druckkraft bei der Montage definiert. Es erfolgt eine Durchbiegung der Gehäusegeometrie während der Montage der Leiterplatte LP3.

Mit Vorteil ist der mechanische Schnappwiderstand beim Eindrücken der Leiterplatte LP3 durch eine Dimensionierung der Schnappzunge SZ2 festlegbar ist. Parameter für die Dimensionierung der Schnappzunge SZ2 sind z.B. die Stärke (Dicke) der Schnappzunge oder ihr Freiheitsgrad bezüglich einer mechanischen Verbiegung).

Mit Vorteil ist der der mechanische Schnappwiderstand beim Eindrücken der Leiterplatte LP3 durch den Abschrägwinkel der abgeschrägten Wand (unterhalb des Steges ST3 in Richtung Leiterplatte LP 3) festlegbar ist.

Mit Vorteil erfolgt eine Fixierung der Gehäuseschale GH2 mit der Leiterplatte LP3 durch eine im wesentlichen bündige Verbindung des Randes einer Aussenwand der Leiterplatte LP3 mit der Stirnkante der Gehäuseschale GH2.

Mit Vorteil weist die Leiterplatte LP3 an einer stirnseitigen Wand eine Ausnehmung AS1 auf, wobei die zwei Aussparungen A4, A5 und die Schnappzunge SZ2 durch die Kontur der Ausnehmung AS1 gebildet sind.

Figur 4 zeigt eine vierte beispielhafte Prinzipdarstellung des erfindungsgemässen Schnappmechanismus zum Fixieren einer Leiterplatte LP4 in einer Gehäuseschale GH3, wobei die Gehäuseschale GH3 in ihrer Geometrie einen Steckerkörper mit einem ersten ESE4 und einem zweiten ZSE3 Steckelement aufweist, wobei ein Steckelement ESE4, ZSE3 jeweils ein zur Leiterplatte LP4 hin abgeschrägtes Einführelement und eine zum Leiterplattenrand weisende Schnappnase SN3, SN4 aufweist; wobei der Steckerkörper zwischen dem ersten ESE4 und dem zweiten ZSE3 Steckelement einen Steg ST4 mit einer zur Leiterplatte hin abgeschrägten Wand aufweist, wodurch eine Haltekante zwischen dem Unterteil der Wand und der Gehäuseschale GH3 an der Innenwand der Gehäuseschale GH3 gebildet wird; wobei die Leiterplatte LP4 zwei Aussparungen A6, A7 aufweist, in die das erste ESE4 und das zweite ZSE3 Steckelement durchgreifen; wobei die Leiterplatte LP4 zwischen den Aussparungen A6, A7 eine Schnappzunge SZ3 aufweist; wobei durch ein mechanisches Eindrücken der Leiterplatte LP4 auf den Steckerkörper durch Anliegen der Schnappzunge SZ3 an der Haltekante und durch formschlüssige Verbindung der Schnappnasen SN3, SN4 mit der Leiterplatte LP4 eine Fixierung der Gehäuseschale GH3 mit der Leiterplatte LP4 erfolgt.

Mit Vorteil weist die Leiterplatte LP4 an einer stirnseitigen Wand eine Ausnehmung AS2 auf, wobei die zwei Aussparungen A6, A7 und die Schnappzunge SZ3 durch die Kontur der Ausnehmung AS2 gebildet sind.

In der Darstellung gemäss Figur 4 zeigt die dunkelgraue Geometrie die Kontur der Leiterplatte LP4 im Bereich der Fixierung mit dem Gehäuse GH3. Die hellgraue Geometrie zeigt die Kontur des Gehäuses GH3 im Bereich der Fixierung mit der Leiterplatte LP4.

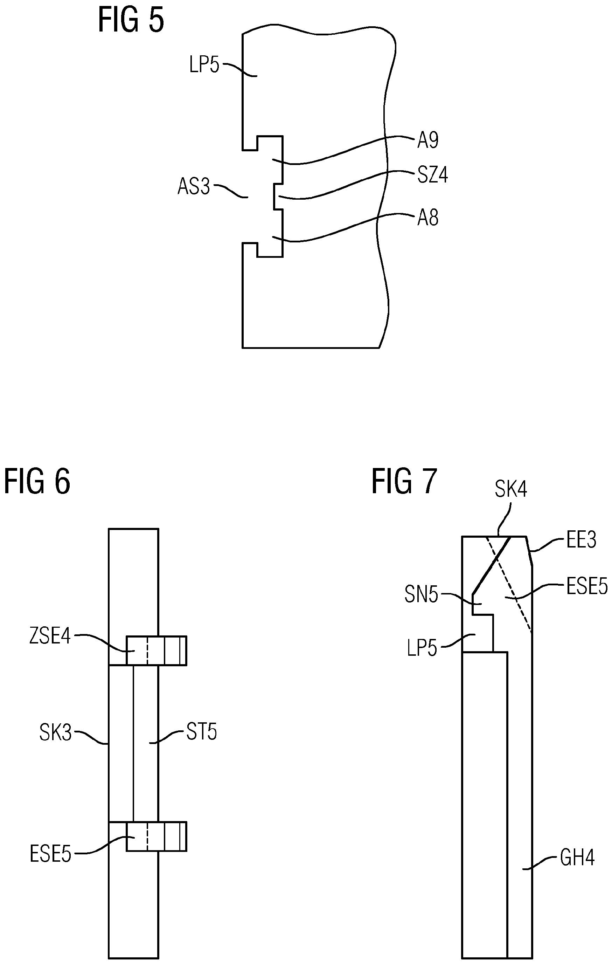

Figur 5 zeigt eine fünfte beispielhafte Prinzipdarstellung des erfindungsgemässen Schnappmechanismus zum Fixieren einer Leiterplatte LP5 in einer Gehäuseschale (die Gehäuseschale ist in der Darstellung gemäss Figur 5 nicht dargestellt), wobei die Gehäuseschale in ihrer Geometrie einen Steckerkörper mit einem ersten und einem zweiten Steckelement aufweist, wobei ein Steckelement ein zur Leiterplatte LP5 hin abgeschrägtes Einführelement und eine zum Leiterplattenrand weisende Schnappnase aufweist; wobei der Steckerkörper zwischen dem ersten und dem zweiten Steckelement einen Steg mit einer zur Leiterplatte LP5 hin abgeschrägten Wand aufweist, wodurch eine Haltekante zwischen dem Unterteil der Wand und der Gehäuseschale an der Innenwand der Gehäuseschale gebildet wird; wobei die Leiterplatte LP5 zwei Aussparungen A8, A9 aufweist, in die das erste und das zweite Steckelement durchgreifen; wobei die Leiterplatte LP5 zwischen den Aussparungen A8, A9 eine Schnappzunge SZ4 aufweist; wobei durch ein mechanisches Eindrücken der Leiterplatte LP5 auf den Steckerkörper durch Anliegen der Schnappzunge SZ4 an der Haltekante und durch formschlüssige Verbindung der Schnappnasen mit der Leiterplatte LP5 eine Fixierung der Gehäuseschale mit der Leiterplatte LP5 erfolgt.

Mit Vorteil weist die Leiterplatte LP5 an einer stirnseitigen Wand eine Ausnehmung AS3 auf, wobei die zwei Aussparungen A8, A9 und die Schnappzunge SZ4 durch die Kontur der Ausnehmung AS3 gebildet sind.

Figur 6 zeigt eine sechste beispielhafte Prinzipdarstellung des erfindungsgemässen Schnappmechanismus zum Fixieren einer Leiterplatte (die Leiterplatte ist in der Darstellung gemäss Figur 6 nicht dargestellt) in einer Gehäuseschale (die Gehäuseschale ist in der Darstellung gemäss Figur 6 nur teilweise dargestellt), wobei die Gehäuseschale in ihrer Geometrie einen Steckerkörper SK3 mit einem ersten ESE5 und einem zweiten ZSE4 Steckelement aufweist, wobei ein jeweiliges Steckelement ESE5, ZSE4 ein zur Leiterplatte hin abgeschrägtes Einführelement und eine zum Leiterplattenrand weisende Schnappnase aufweist; wobei der Steckerkörper SK3 zwischen dem ersten ESE5 und dem zweiten ZSE4 Steckelement einen Steg ST5 mit einer zur Leiterplatte hin abgeschrägten Wand aufweist, wodurch eine Haltekante zwischen dem Unterteil der Wand und der Gehäuseschale an der Innenwand der Gehäuseschale gebildet wird; wobei die Leiterplatte zwei Aussparungen aufweist, in die das erste ESE5 und das zweite ZSE4 Steckelement durchgreifen; wobei die Leiterplatte zwischen den Aussparungen eine Schnappzunge aufweist; wobei durch ein mechanisches Eindrücken der Leiterplatte auf den Steckerkörper SK3 durch Anliegen der Schnappzunge an der Haltekante und durch formschlüssige Verbindung der Schnappnasen mit der Leiterplatte eine Fixierung der Gehäuseschale mit der Leiterplatte erfolgt.

Figur 7 zeigt eine siebte beispielhafte Prinzipdarstellung des erfindungsgemässen Schnappmechanismus zum Fixieren einer Leiterplatte LP5 in einer Gehäuseschale GH4, wobei die Gehäuseschale GH4 in ihrer Geometrie einen Steckerkörper SK4 mit einem ersten ESE5 und einem zweiten Steckelement aufweist (in der Schnittdarstellung gemäss Figur 7 ist das zweite Steckelement nicht sichtbar), wobei ein Steckelement ESE5 jeweils ein zur Leiterplatte hin abgeschrägtes Einführelement EE3 und eine zum Leiterplattenrand weisende Schnappnase SN5 aufweist; wobei der Steckerkörper SK4 zwischen dem ersten und dem zweiten Steckelement einen Steg mit einer zur Leiterplatte LP5 hin abgeschrägten Wand aufweist, wodurch eine Haltekante zwischen dem Unterteil der Wand und der Gehäuseschale an der Innenwand der Gehäuseschale GH4 gebildet wird; wobei die Leiterplatte zwei Aussparungen (in der Darstellung gemäss Figur 7 nicht sichtbar) aufweist, in die das erste ESE5 und das zweite Steckelement durchgreifen; wobei die Leiterplatte LP5 zwischen den Aussparungen eine Schnappzunge (in der Darstellung gemäss Figur 7 nicht sichtbar) aufweist; wobei durch ein mechanisches Eindrücken der Leiterplatte LP5 auf den Steckerkörper SK4 durch Anliegen der Schnappzunge an der Haltekante und durch formschlüssige Verbindung der Schnappnasen SN5 mit der Leiterplatte LP5 eine Fixierung der Gehäuseschale GH4 mit der Leiterplatte LP5 erfolgt.

Der erfindungsgemässe Schnappmechanismus ermöglicht eine schnelle und schraubenlose Fixierung einer Leiterplatte in einem, insbesondere in nur einem, Kunststoffgehäuse. Dies erfolgt ohne Zuhilfenahme eines Werkzeugs. Eine Leiterplatte kann ohne weitere Komponenten (z.B. zweite Gehäusehälfte) vollständig in ihrer Position fixiert werden. Unter dem Begriff Leiterplatte ist hier immer sowohl die einzelne Leiterplatte als auch die bestückte Leiterplatte, also die Flachbaugruppe zu verstehen.

Durch eine spezielle Geometrie in der Leiterplatte wird im Zusammenwirken mit dem entsprechenden Gegenstück, also durch eine entsprechende Geometrie im Kunststoffgehäuse, die Leiterplatte, vollständig in ihrer Lage fixiert. Eine Fixierung ist auch für andere relativ unflexible Komponenten möglich.

Dies ist werkzeuglos und ohne zusätzliche Komponenten (z.B. Gegenstücke) möglich. Zur vollständigen Verbindung bzw. Fixierung dieser beiden unterschiedlichen Komponenten (Kunststoffgehäuse und Leiterplatte) sind keine weiteren Teile notwendig.

Die Vorteile des erfindungsgemässen Schnappmechanismus sind insbesondere:
- Kein Montagewerkzeug notwendig
- Keine zusätzlichen Komponenten notwendig
- Beide Komponenten sind bereits als Halb vollständig miteinander verbunden und brauchen für den weiteren Fertigungsprozess nicht mehr speziell zueinander fixiert werden. Dies bedeutet einen Geringen Händlingsaufwand.
- Die für die Montage der Leiterplatte notwendige Drucckraft zur Überwindung des Schnappwiederstandes kann jederzeit und ohne anfallende Werkzeugkosten des Gehäusewerkzeugs angepasst werden. Dies kann z.B. im Zuge einer Leiterplattenänderung mitgemacht werden, indem die "Zunge" der Leiterplatte vergrößert (Erhöhung des Schnappwiederstandes) oder verkleiner (Verringerung des Schnappwiederstandes) wird.
- Geringere Montagezeit
- Geringere Fertigungskosten
- Nur ein Montageschritt notwendig für die vollständige Fixierung der Leiterplatte in insbesondere nur einem Gehäuseteil, ohne Zuhilfenahme von Werkzeug oder zusätzlichen Komponenten. Zusätzlich kann die Druckkraft die zur Montage der Leiterplatte benötigt wird ohne großen Aufwand im Nachhinein noch verändert/optimiert (z.B. durch entsprechende Dimensionierung der Schnappzunge) werden.
- Der Schnappmechanismus ist nicht nur für Leiterplattenmontage einsetzbar, sondern auch weitere Teile bzw. Komponenten, die eine ähnlich Kombination der Geometrien im Unterteil und der Leiterplatte aufweisen, sind durch den Schnappmechanismus fixierbar. Im Prinzip auch starre Teile.

Schnappmechanismus, zum Fixieren einer Leiterplatte in einer Gehäuseschale, wobei die Gehäuseschale in ihrer Geometrie einen Steckerkörper mit einem ersten und einem zweiten Steckelement aufweist, wobei ein Steckelement ein zur Leiterplatte hin abgeschrägtes Einführelement und eine zum Leiterplattenrand weisende Schnappnase aufweist; wobei der Steckerkörper zwischen dem ersten und dem zweiten Steckelement einen Steg mit einer zur Leiterplatte hin abgeschrägten Wand aufweist, wodurch an der Innenwand des Steckerkörpers eine Haltekante gebildet wird, insbesondere zwischen dem Unterteil der Wand und der Gehäuseschale an der Innenwand der Gehäuseschale; wobei die Leiterplatte zwei Aussparungen aufweist, in die das erste und das zweite Steckelement durchgreifen; wobei die Leiterplatte zwischen den Aussparungen eine Schnappzunge aufweist; wobei durch ein mechanisches Eindrücken der Leiterplatte auf den Steckerkörper durch Anliegen der Schnappzunge an der Haltekante und durch formschlüssige Verbindung der Schnappnasen mit der Leiterplatte eine Fixierung der Gehäuseschale mit der Leiterplatte erfolgt.

### Bezugszeichen

- GH1 - GH4: Gehäuse
- SK1 - SK4: Steckerkörper
- ST1 - ST5: Steg
- ESE1 - ESE5: Erstes Steckelement
- ZSE1 - ZSE4: Zweites Steckelement
- EE1 - EE3: Einführelement
- SN1 - SN5: Schnappnase
- LP1 - LP5: Leiterplatte
- AS1 - AS3: Ausnehmung
- A1 - A7: Aussparung
- SZ1 - SZ4: Schnappzunge
- WA: Wand
- HK: Haltekante

## Patentansprüche

1. Schnappmechanismus zum Fixieren einer Leiterplatte (LP1 - LP5) in einer Gehäuseschale (GH1 - GH4),
wobei die Gehäuseschale (GH1 - GH4) in ihrer Geometrie einen Steckerkörper (SK1 - SK4) mit einem ersten (ESE1 - ESE5) und einem zweiten (ZSE1 - ZSE4) Steckelement aufweist, wobei ein Steckelement (ESE1 - ESE5, ZSE1 - ZSE4) ein zur Leiterplatte (LP1 - LP5) hin abgeschrägtes Einführelement (EE1 - EE3) und eine zum Leiterplattenrand weisende Schnappnase (SN1 - SN5) aufweist;
wobei der Steckerkörper (SK1 - SK4) zwischen dem ersten (ESE1 - ESE5) und dem zweiten (ZSE1 - ZSE4) Steckelement einen Steg (ST1 - ST5) mit einer zur Leiterplatte (LP1 - LP5) hin abgeschrägten Wand (WA) aufweist, wodurch an der Innenwand des Steckerkörpers (SK1 - SK4) eine Haltekante (HK) gebildet wird;
wobei die Leiterplatte (LP1 - LP5) zwei Aussparungen (A1 - A7) aufweist, in die das erste (ESE1 - ESE5) und das zweite (ZSE1 - ZSE4) Steckelement durchgreifen;
wobei die Leiterplatte (LP1 - LP5) zwischen den Aussparungen (A1 - A7) eine Schnappzunge (SZ1 - SZ4) aufweist;
wobei durch ein mechanisches Eindrücken der Leiterplatte (LP1 - LP5) auf den Steckerkörper (SK1 - SK4) durch Anliegen der Schnappzunge (SZ1 - SZ4) an der Haltekante (HK) und durch formschlüssige Verbindung der Schnappnasen (SN1 - SN5) mit der Leiterplatte (LP1 - LP5) eine Fixierung der Gehäuseschale (GH1 - GH4) mit der Leiterplatte (LP1 - LP5) erfolgt, **dadurch gekennzeichnet, dass**
die Schnappnasen (SN1 - SN5) im montierten Zustand der Leiterplatte (LP1 - LP5) von den Aussparungen (A1 - A7) aus über die Oberfläche eines Abschnitts der Leiterplatte zum Rand der Leiterplatte (LP1 - LP5) hinragen und so die formschlüssige Verbindung bilden.

2. Schnappmechanismus nach Anspruch 1, wobei die Leiterplatte (LP1 - LP5) an einer stirnseitigen Wand eine Ausnehmung (AS1 - AS3) aufweist, wobei die zwei Aussparungen (A1 - A7) und die Schnappzunge (SZ1 - SZ4) durch die Kontur der Ausnehmung (AS1 - AS3) gebildet sind.

3. Schnappmechanismus nach einem der vorstehenden Ansprüche, wobei der mechanische Schnappwiderstand beim Eindrücken der Leiterplatte (LP1 - LP5) durch eine Dimensionierung der Schnappzunge (SZ1 - SZ4) festlegbar ist.

4. Schnappmechanismus nach einem der vorstehenden Ansprüche, wobei der mechanische Schnappwiderstand beim Eindrücken der Leiterplatte (LP1 - LP5) durch den Abschrägwinkel der abgeschrägten Wand (WA) festlegbar ist.

5. Schnappmechanismus nach einem der vorstehenden Ansprüche, wobei eine Fixierung der Gehäuseschale (GH1 - GH4) mit der Leiterplatte (LP1 - LP5) weiterhin erfolgt durch eine bündige Verbindung des Randes einer Aussenwand der Leiterplatte (LP1 - LP5) mit der Stirnkante der Gehäuseschale (GH1 - GH4).

6. Schnappmechanismus nach einem der vorstehenden Ansprüche, wobei durch ein mechanisches Eindrücken der Leiterplatte (LP1 - LP5) auf den Steckerkörper (SK1 - SK4) durch Einrasten der Schnappzunge (SZ1 - SZ4) in der Haltekante (HK), durch formschlüssige Verbindung der Schnappnasen (SN1 - SN5) mit der Leiterplatte (LP1 - LP5), und durch die bündige Verbindung des Randes einer Aussenwand der Leiterplatte (LP1 - LP5) mit der Stirnkante der Gehäuseschale (GH1 - GH4) eine Fixierung der Leiterplatte (LP1 - LP5) in horizontaler und/oder vertikaler Richtung in Bezug zur Lage der Gehäuseschale (GH1 - GH4) erfolgt.

7. System zur Fixierung einer Leiterplatte (LP1 - LP5) in einem Gehäuseteil, insbesondere in einer Gehäuseschale (GH1 - GH4), das System umfassend einen Schnappmechanismus nach einem der vorstehenden Ansprüche.

8. System nach Anspruch 7, wobei das Gehäuseteil (GH1 - GH4) und die im Gehäuseteil (GH1 - GH4) zu fixierende Leiterplatte (LP1 - LP5) dazu ausgebildet sind, dass sich zwei Schnappmechanismen, jeweils nach einem der Ansprüche 1 bis 6, an einander gegenüberliegenden Stirnseiten der Leiterplatte (LP1 - LP5) befinden.

9. Teilnehmer eines Installationsbusses, der mindestens einen Schnappmechanismus nach einem der vorstehenden Ansprüche 1 - 6 umfasst, zur Fixierung einer Leiterplatte (LP1 - LP5) in einem Gehäuseteil (GH1 - GH4) des Teilnehmers.

## Claims

1. Snap mechanism for fixing a PCB (LP1 - LP5) in a housing shell (GH1 - GH4),
wherein the geometry of the housing shell (GH1 - GH4) has a connector body (SK1 - SK4) with a first (ESE1 - ESE5) and a second (ZSE1 - ZSE4) plug-in element, wherein a plug-in element (ESE1 - ESE5, ZSE1 - ZSE4) has an insertion element (EE1 - EE3) which is chamfered towards the PCB (LP1 - LP5) and a snap-in lug (SN1 - SN5) pointing towards the edge of the PCB;
wherein the connector body (SK1 - SK4) has a web (ST1 - ST5) with a wall (WA) chamfered towards the PCB (LP1 - LP5) between the first (ESE1 - ESE5) and the second (ZSE1 - ZSE4) plug-in element, whereby a retaining edge (HK) is formed on the inner wall of the connector body (SK1 - SK4);
wherein the PCB (LP1 - LP5) has two recesses (A1 - A7), into which the first (ESE1 - ESE5) and the second (ZSE1 - ZSE4) plug-in element engage;
wherein the PCB (LP1 - LP5) has a snap tongue (SZ1 - SZ4) between the recesses (A1 - A7);
wherein by mechanically pressing the PCB (LP1 - LP5) into the connector body (SK1 - SK4) by abutting the snap tongue (SZ1 - SZ4) against the retaining edge (HK) and by form-fit connection of the snap lugs (SN1 - SN5) to the PCB (LP1 - LP5) the housing shell (GH1 - GH4) is fixed to the PCB (LP1 - LP5), **characterised in that**
in the mounted state of the PCB (LP1 - LP5) the snap lugs (SN1 - SN5) project from the recesses (A1 - A7) out over the surface of a section of the PCB to the edge of the PCB (LP1 - LP5) and thus form the form-fit connection.

2. Snap mechanism according to claim 1, wherein the PCB (LP1 - LP5) has a recess (AS1 - AS3) on an end wall, wherein the two recesses (A1 - A7) and the snap tongue (SZ1 - SZ4) are formed by the contour of the recess (AS1 - AS3).

3. Snap mechanism according to one of the preceding claims, wherein the mechanical snap resistance can be determined by a dimensioning of the snap tongue (SZ1 - SZ4) when pressing the PCB (LP1 - LP5) in.

4. Snap mechanism according to one of the preceding claims, wherein the mechanical snap resistance can be determined by the chamfer angle of the chamfered wall (WA) when pressing the PCB (LP1 - LP5) in.

5. Snap mechanism according to one of the preceding claims, wherein the housing shell (GH1 - GH4) is further fixed to the PCB (LP1 - LP5) by a flush connection of the edge of an outer wall of the PCB (LP1 - LP5) to the front edge of the housing shell (GH1 - GH4).

6. Snap mechanism according to one of the preceding claims, wherein by mechanically pressing the PCB (LP1 - LP5) into the connector body (SK1 - SK4) by latching the snap tongue (SZ1 - SZ4) in the retaining edge (HK), by form-fit connection of the snap lugs (SN1 - SN5) to the PCB (LP1 - LP5), and by the flush connection of the edge of an outer wall of the PCB (LP1 - LP5) to the front edge of the housing shell (GH1 - GH4) the PCB (LP1 - LP5) is fixed in a horizontal and/or vertical direction in relation to the position of the housing shell (GH1 - GH4).

7. System for fixing a PCB (LP1 - LP5) in a housing part, in particular in a housing shell (GH1 - GH4), the system comprising a snap mechanism according to one of the preceding claims.

8. System according to claim 7, wherein the housing part (GH1 - GH4) and the PCB (LP1 - LP5) to be fixed in the housing part (GH1 - GH4) are embodied such that two snap mechanisms, each according to one of claims 1 to 6, are located on opposing end faces of the PCB (LP1 - LP5).

9. User of an installation bus, which comprises at least one snap mechanism according to one of the preceding claims 1 - 6, for fixing a PCB (LP1 - LP5) in a housing part (GH1 - GH4) of the user.

## Revendications

1. Mécanisme à encliquetage de fixation d'un circuit imprimé (LP1 - LP5) dans une coque de boîtier (GH1 - GH4),
dans lequel la coque de boîtier (GH1 - GH4) présente un corps de fiche (SK1 - SK4) avec un premier (ESE1 - ESE5) et un second (ZSE1 - ZSE4) élément d'enfichage dans sa géométrie, dans lequel un élément d'enfichage (ESE1 - ESE5, ZSE1 - ZSE4) présente un élément d'insertion (EE1 - EE3) qui est biseauté vers le circuit imprimé (LP1 - LP5) et un taquet à encliquetage (SN1 - SN5) pointant vers le bord de circuit imprimé ;
dans lequel le corps de fiche (SK1 - SK4) présente, entre le premier (ESE1 - ESE5) et le second (ZSE1 - ZSE4) élément d'enfichage, une nervure (ST1 - ST5) avec une paroi (WA) biseautée vers le circuit imprimé (LP1 - LP5), moyennant quoi un bord de retenue (HK) est formé sur la paroi intérieure du corps de fiche (SK1 - SK4) ;
dans lequel le circuit imprimé (LP1 - LP5) présente deux évidements (A1 - A7) dans lesquels s'étendent le premier (ESE1 - ESE5) et le second (ZSE1 - ZSE4) élément d'enfichage ;
dans lequel le circuit imprimé (LP1 - LP5) présente une languette à encliquetage (SZ1 - SZ4) entre les évidements (A1 - A7) ;
dans lequel, par une pression mécanique du circuit imprimé (LP1 - LP5) sur le corps de fiche (SK1 - SK4) par l'appui de la languette à encliquetage (SZ1 - SZ4) sur le bord de retenue (HK) et par une liaison par complémentarité de forme des taquets à encliquetage (SN1 - SN5) au circuit imprimé (LP1 - LP5), une fixation de la coque de boîtier (GH1 - GH4) sur le circuit imprimé (LP1 - LP5) a lieu,
**caractérisé en ce que**
les taquets à encliquetage (SN1 - SN5) à l'état assemblé du circuit imprimé (LP1 - LP5) font saillie depuis les évidements (A1 - A7) sur la surface d'une section du circuit imprimé jusqu'au bord du circuit imprimé (LP1 - LP5) et forment ainsi la liaison par complémentarité de forme.

2. Mécanisme à encliquetage selon la revendication 1, dans lequel le circuit imprimé (LP1 - LP5) présente un évidement (AS1 - AS3) sur une paroi du côté frontal, dans lequel les deux évidements (A1 - A7) et la languette à encliquetage (SZ1 - SZ4) sont formés à travers le contour de l'évidement (AS1 - AS3).

3. Mécanisme à encliquetage selon l'une des revendications précédentes, dans lequel la résistance mécanique de l'encliquetage peut être définie lors de la pression du circuit imprimé (LP1 - LP5) par un dimensionnement de la languette à encliquetage (SZ1 - SZ4).

4. Mécanisme à encliquetage selon l'une des revendications précédentes, dans lequel la résistance mécanique de l'encliquetage peut être définie lors de la pression du circuit imprimé (LP1 - LP5) par l'angle de biseautage de la paroi biseautée (WA).

5. Mécanisme à encliquetage selon l'une des revendications précédentes, dans lequel une fixation de la coque de boîtier (GH1 - GH4) au circuit imprimé (LP1 - LP5) a également lieu par une liaison affleurante du bord d'une paroi extérieure du circuit imprimé (LP1 - LP5) au bord frontal de la coque de boîtier (GH1 - GH4).

6. Mécanisme à encliquetage selon l'une des revendications précédentes, dans lequel, par un appui mécanique du circuit imprimé (LP1 - LP5) sur le corps de fiche (SK1 - SK4) par l'encliquetage de la languette à encliquetage (SZ1 - SZ4) dans le bord de retenue (HK), par une liaison par complémentarité de forme des taquets à encliquetage (SN1 - SN5) avec le circuit imprimé (LP1 - LP5), et par la liaison affleurante du bord d'une paroi extérieure du circuit imprimé (LP1 - LP5) avec le bord frontal de la coque de boîtier (GH1 - GH4), une fixation du circuit imprimé (LP1 - LP5) dans une direction horizontale et/ou verticale par rapport à la position de la coque de boîtier (GH1 - GH4) a lieu.

7. Dispositif de fixation d'un circuit imprimé (LP1 - LP5) dans une partie de boîtier, en particulier dans une coque de boîtier (GH1 - GH4), le dispositif comprenant un mécanisme à encliquetage selon l'une des revendications précédentes.

8. Dispositif selon la revendication 7, dans lequel la partie de boîtier (GH1 - GH4) et le circuit imprimé (LP1 - LP5) à fixer dans la partie de boîtier (GH1 - GH4) sont conçus de sorte que deux mécanismes à encliquetage, chacun selon l'une des revendications 1 à 6, se trouvent sur des faces frontales opposées l'une à l'autre du circuit imprimé (LP1 - LP5).

9. Participant d'un bus d'installation, qui comprend au moins un mécanisme à encliquetage selon l'une des revendications 1 à 6 précédentes, pour fixer un circuit imprimé (LP1 - LP5) dans une partie de boîtier (GH1 - GH4) du participant.
